# FASCICULE DE BREVET EUROPEEN

(11) **EP 1 135 979 B1**
(45) Date de publication et mention de la délivrance du brevet: **12.02.2003**
(21) Numéro de dépôt: 98955303.7
(22) Date de dépôt: 02.12.1998
(51) Int. Cl.: H05K 13/02, H05K 13/04

(54) **DISPOSITIF DE SAISIE ET D'ALIGNEMENT D'UN COMPOSANT ELECTRONIQUE SUR UNE BROCHE**
VORRICHTUNG ZUR ERFASSUNG UND AUSRICHTUNG EINES ELEKTRONISCHEN BAUELEMENTES MIT EINER SPINDEL
DEVICE FOR GRASPING AND ALIGNING AN ELECTRONIC COMPONENT ON A SPINDLE

(43) Date de publication de la demande: 26.09.2001
(73) Titulaire: Ismeca Holding SA, 2301 La Chaux-de-Fonds (CH)
(72) Inventeur: MATHEZ, Claudio, CH-2300 La Chaux-de-Fonds (CH)
(74) Mandataire: Saam, Christophe
(86) Numéro de dépôt international: CH9800509
(87) Numéro de publication internationale: WO00033630

(56) Documents cités:
- EP-A- 0 817 559
- US-A- 4 860 439
- US-A- 4 950 011

## Description

La présente invention concerne un dispositif par lequel il est possible de saisir et d'aligner un composant électronique, notamment un composant électronique muni d'un circuit intégré et comportant une pluralité de pattes de contact, sur une broche de saisie.

Un composant électronique tel que mentionné est généralement constitué d'un boîtier en matériau synthétique enfermant le circuit intégré, une pluralité de pattes de contact métalliques, destinées à la transmission des signaux électroniques vers et du circuit intégré ainsi qu'à la fixation dudit composant par soudage ou tout autre moyen sur un socle ou une portion de carte de circuit imprimé, s'étendant en saillie sur au moins une face du boîtier. Un tel composant est généralement de très faibles dimensions, de l'ordre de quelques mm, et est donc difficilement manipulable.

Lors d'une étape du processus de fabrication, généralement en fin de processus, le composant est testé électriquement sur un poste de test adéquat. Pour ceci, le composant, maintenu sur une broche de saisie, est amené en face d'une portion de test dudit poste de test, chacune des pattes de contact du composant étant mise en contact avec une piste métallique correspondante du poste de test, afin de pouvoir vérifier la qualité du composant. Vu les faibles dimensions mentionnées dudit composant cette opération est très délicate.

Un problème similaire se pose lorsque le composant est à fixer sur un socle ou une portion de carte de circuit imprimé.

Généralement pour ceci le composant, qui est disposé sur un premier dispositif de maintien de composant, son alignement relativement audit dispositif de maintien étant approximativement connu, est saisi par le boîtier à l'aide d'un dispositif à pince saisissant deux faces opposées du boîtier ne comportant pas de pattes de contact, puis le dispositif à pince portant le composant est amené vers le poste de test où des moyens de reconnaissance d'image et de positionnement du dispositif à pince, ou du dispositif de test, sont généralement utilisés pour aligner le composant de manière à ce que ses pattes de contact arrivent exactement en regard des pistes de contact correspondantes du poste de test. Un tel dispositif est compliqué et nécessite notamment des moyens actifs permettant d'ajuster la position relative du dispositif à pince et du poste de test selon au moins deux axes perpendiculaires ainsi qu'un axe de rotation, ainsi que des moyens de calcul importants pour la reconnaissance d'image, notamment dans le cas où plusieurs composants doivent être alignés simultanément D'autres dispositifs prévoient de saisir, à l'aide d'une butée, une référence de position par une portion du boîtier du composant, par exemple un coin, une face ou un dispositif de détrompage du boîtier, puis d'aligner le composant dès que cette référence est connue. En plus des moyens de positionnement actifs nécessaires comme précédemment, ce dispositif possède l'inconvénient de fixer la référence de position sur le boîtier, ce qui peut amener à un mauvais alignement des pattes de contact dans le cas où celles-ci seraient légèrement décalées relativement au boîtier. Dans tous les cas où le composant est saisi par un dispositif à pince saisissant deux faces du boîtier, les pattes de contact sont peu accessibles vu l'encombrement de la pince autour dudit composant.

Le document EP-0.817.559 décrit un dispositif de saisie et d'alignement assez semblable à celui proposé ici, si ce n'est que l'alignement du composant se fait par un mouvement vertical relativement à un cadre entourant ledit composant et muni de parois obliques formant une sorte d'entonnoir.

Le document US-4.860.439 décrit un dispositif d'alignement à pince pour un composant électronique de type PGA.

Un premier but de l'invention est de proposer un dispositif permettant de saisir puis d'aligner un composant électronique sur une broche de saisie ne rencontrant pas les inconvénients des dispositifs connus, et par lequel notamment le composant est aligné en prenant directement comme référence la position des pattes de contact du composant.

Un deuxième but de l'invention est de proposer un dispositif de saisie et d'alignement ne comportant aucun moyen de positionnement actif motorisé entre la broche de saisie et un poste de traitement du composant, pouvant être un poste de test ou un poste de fixation, pour l'ajustage final de position entre ces deux éléments.

Ces buts sont obtenus par un dispositif de saisie et d'alignement d'un composant électronique sur une broche tel que décrit dans la partie caractérisante de la revendication 1, des variantes ou formes d'exécution particulières étant décrites dans les revendications dépendantes.

Une forme d'exécution préférentielle d'un dispositif selon l'invention est décrite ci-dessous, cette description étant à considérer en regard du dessin annexé comportant les figures où :
la figure 1 représente une coupe longitudinale d'une broche de saisie d'un composant électronique en position de saisie d'un composant,
les figures 2A et 2B représentent une coupe longitudinale d'un dispositif d'alignement en position ouverte, respectivement en position fermée,
les figures 3A et 3B représentent le fonctionnement des mâchoires des dispositifs d'alignement des figures 2A et 2B vues selon la ligne III-III desdites figures, et
la figure 4 représente la même broche de saisie que celle de la figure 1 en face d'un dispositif de test de composant.

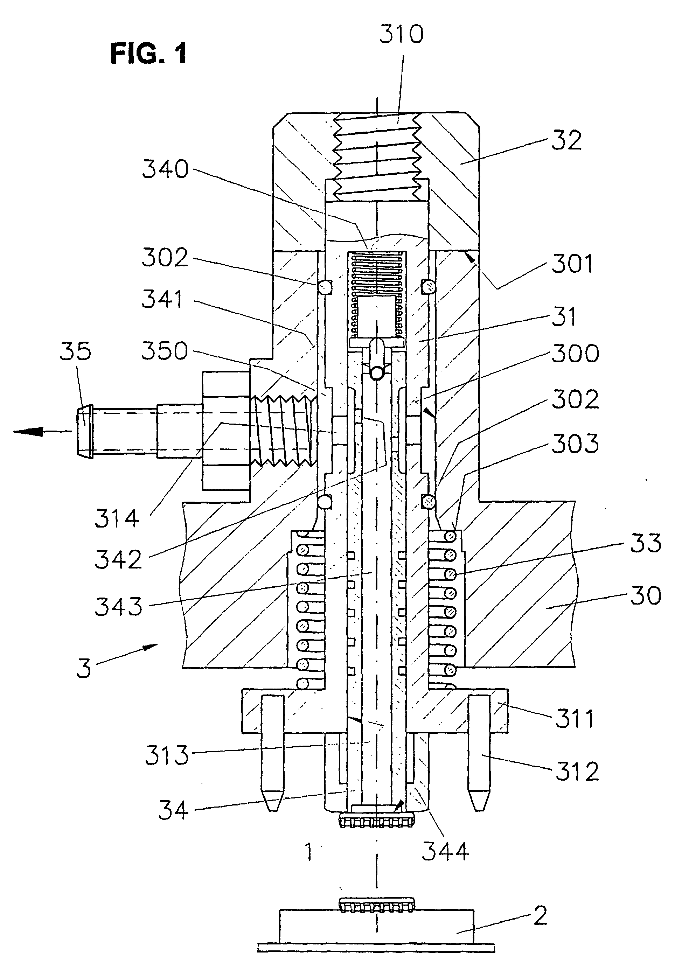

La figure 1 montre un composant 1, dans cet exemple un composant de type « dual in line » comportant des pattes de contact uniquement sur deux faces opposées du boîtier, placé sur un porte-composant 2 de n'importe quel type, pouvant faire partie d'un carrousel ou d'une ligne de fabrication dudit composant 1. Une broche de saisie 3 est destinée à venir saisir le composant 1 sur le porte-composant 2 pour l'emmener vers un poste de traitement ultérieur. La broche de saisie 3 comprend un cadre support 30 comportant un perçage cylindrique traversant 300. Une douille mobile 31 est disposée à l'intérieur du perçage cylindrique 300, étant fixée par un écrou 32 vissé sur un filetage 310 d'une première extrémité de la douille mobile 31, une face dudit écrou 32 prenant appui contre une face opposée 301 du support 30. On voit sur la figure que le diamètre extérieur de la douille 31 est nettement inférieur au diamètre intérieur du perçage cylindrique 300, de manière à laisser un jeu entre ces deux éléments. Deux joints toriques 302, disposés dans des rainures périphériques aménagées sur la douille 31 ou dans le perçage 300 maintiennent latéralement la douille 31 à l'intérieur du perçage 300. L'extrémité de la douille 31 opposée à celle munie de l'écrou 32, faisant saillie hors du perçage 300, comprend une bague d'appui et de positionnement 311. Un moyen à ressort, par exemple un ressort à boudin 33 prend appui d'une part sur la face de la bague d'appui 311 faisant face au support 30 et d'autre part contre un épaulement 303 aménagé dans le perçage 300. De cette manière, la bague d'appui 311 est maintenue éloignée de la paroi qui lui fait directement face du support 30. La bague d'appui 311 comprend en outre des moyens de guidage 312 dont l'utilité sera décrite plus tard. Un tube coulissant 34 est disposé à l'intérieur d'un autre perçage cylindrique 313 aménagé dans la douille 31. Une première extrémité du tube coulissant 34 est fixée par un ressort 340 à l'intérieur du perçage 313 alors que l'autre extrémité du tube coulissant 34 fait légèrement saillie hors du perçage 313, respectivement hors de la face inférieure de la douille 31 et forme l'extrémité de saisie 344 de la broche 3. La constante du ressort 340 est inférieure à la constante du ressort 33.

La construction flottante de la broche 3 qui vient d'être décrite permet d'une part une saisie et une pose en douceur du composant 1 et d'autre part un ajustage de position entre la broche 3 et le poste de test ou le poste de traitement ne nécessitant aucun moyen actif de déplacement. Lorsque le support 30 est immobile, une légère pression mécanique exercée sur l'extrémité en saillie du tube coulissant 34 fait rentrer ledit tube à l'intérieur du perçage 313 en comprimant le ressort 340, en continuant à appliquer cette pression, on vient alors comprimer le ressort 33, faisant se rapprocher la bague d'appui 311 de la paroi inférieure du support 30, faisant du même coup décoller l'écrou 32 de la paroi 301 du support. A ce moment, la douille 31 supportant le tube coulissant 34 n'est plus supportée que par le ressort 33 et les deux joints toriques 302. Vu l'élasticité de ces éléments ainsi que le jeu entre la surface extérieure de la douille 31 et le diamètre intérieur du perçage 300, il devient possible de déplacer latéralement l'extrémité de la douille 31, respectivement du tube coulissant 34, selon les deux axes perpendiculaires X et Y d'un plan perpendiculaire à l'axe longitudinal de la douille 31 ainsi que de faire pivoter légèrement ladite douille ou ledit tube coulissant autour dudit axe longitudinal.

La broche de saisie 3 est complétée d'un dispositif d'aspiration comprenant un embout 35 fixé sur le support 30. Ledit embout étant relié d'une part à une unité d'aspiration, non représentée sur la figure, et d'autre part à une première chambre 350 disposée entre la surface extérieure de la douille 31 et le diamètre intérieur du perçage 300, ladite chambre étant limitée longitudinalement par les deux joints toriques 302, assurant l'étanchéité de ladite chambre en plus de leur fonction de support de la douille 31 décrite plus haut. Une communication radiale est aménagée par le trou 314 aménagé à travers la paroi de la douille 31 qui relie la première chambre 350 à une deuxième chambre 341 aménagée entre la douille 31 et le tube coulissant 34, puis par le trou 342 aménagé dans la paroi du tube coulissant et débouchant dans l'évidemment central d'aspiration 343 du tube d'aspiration. L'évidemment central débouche sur l'extrémité de saisie 344 du tube d'aspiration, en saillie hors de la douille 31. La conformation décrite du passage d'aspiration entre l'embout 35 et l'évidemment central 343 permet le passage de l'air d'aspiration quelles que soient les positions longitudinales et angulaires relatives entre les divers éléments décrits.

Afin de saisir un composant 1, comme on le voit à la figure 1, la broche 3 est amenée à proximité du porte-composant 2, de manière à ce que l'extrémité de saisie 344 du tube d'aspiration soit alignée selon l'axe longitudinal de la broche 3 par rapport au porte-composant 2. Sur ce dernier, le composant 1 est disposé de manière quelconque relativement aux axes perpendiculaires à l'axe longitudinal de la broche de saisie et selon un angle quelconque autour du même axe longitudinal, mais avec une précision suffisante pour que, lorsque l'extrémité de saisie 344 est approchée de la surface supérieure du composant 1, cette surface bouche entièrement l'orifice d'aspiration de l'extrémité de saisie afin que le composant puisse être aspiré par ladite extrémité de saisie 344 lorsqu'une dépression est introduite par l'embout 35, se propageant comme décrit jusqu'à l'extrémité de saisie 344.

Lorsqu'il a été saisi comme indiqué le composant 1 est maintenu par dépression sur l'extrémité de saisie 344 de la broche 3, sa position selon les deux axes perpendiculaires à l'axe longitudinal de la broche ainsi que l'angle autour de cet axe n'étant pas exactement déterminée.

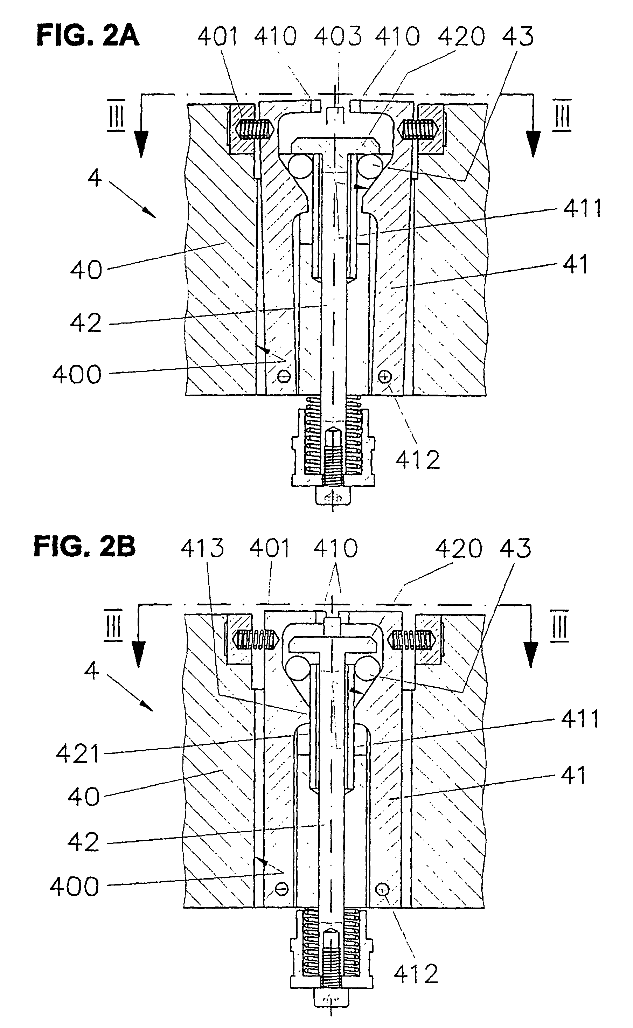

Le dispositif permettant d'aligner exactement le composant 1 sur la broche 3 est décrit aux figures 2A et 2B ainsi que 3A et 3B

La figure 2A montre un dispositif d'alignement 4 en position ouverte, soit prêt à recevoir un composant à aligner. Le composant n'est pas représenté sur les figures 2A et 2B afin de ne pas les surcharger. Le dispositif est constitué d'un châssis 40 comprenant un perçage 400 contenant deux branches d'une pince 41, chacune des branches comportant une mâchoire d'alignement 410. La partie centrale de la pince 41 est creuse de manière à laisser la place à une tige d'ouverture 42, comprenant une extrémité munie d'une butée 420. La portion interne des branches de la pince 41 comprend une section conique 411, sur laquelle viennent s'appuyer une pluralité de billes 43 emprisonnées entre ladite section conique 411 et la portion interne de la butée 420. Chaque branche de la pince 41 est montée de manière pivotante sur un axe 412. Deux ressorts 401 tendent à refermer la pince 41. En repoussant la tige d'ouverture 42, comme on le voit à la figure 2B, les billes 43 sont libérées par la butée 420 et peuvent donc se déplacer vers la portion la plus évasée de la section conique 411, ce qui permet le rapprochement des mâchoires 410. Deux butées 413 venant en appui contre une douille 421 entourant la tige 42 permettent de limiter le mouvement de fermeture des mâchoires 410, de manière à éviter d'écraser ou déformer les pattes du composant.

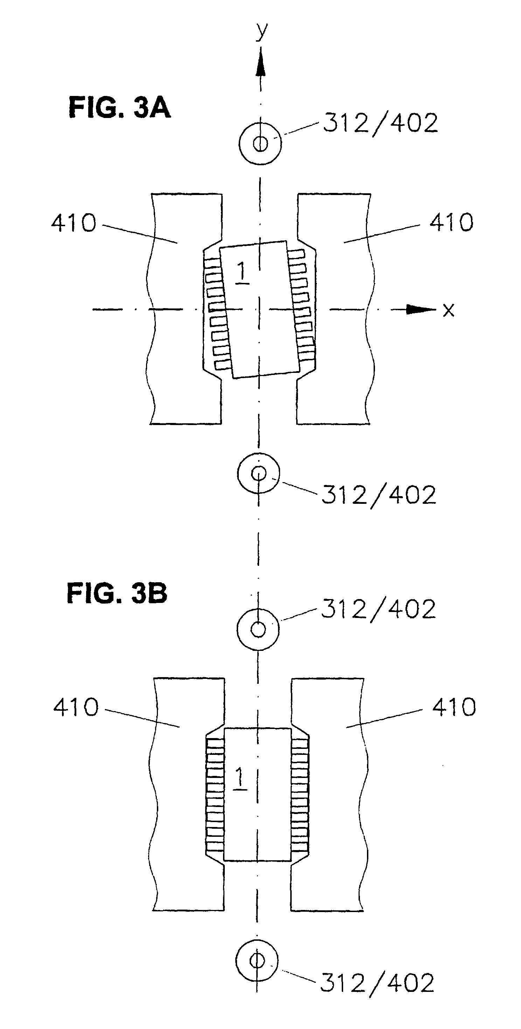

Les figures 3A et 3B qui sont des vues selon les flèches III-III des figures 2A et 2B représentent la forme des mâchoires 410 et leur action d'alignement du composant 1. Le composant 1 porté comme indiqué plus haut par la broche 3, est amené en face d'un dispositif d'alignement 4 dont les mâchoires 410 sont ouvertes. La broche 3 est alors rapprochée du dispositif d'alignement, les moyens de guidage 312 de la broche 3 (voir figure 1) constitués par exemple de deux tiges à extrémité conique en saillie, sont introduites dans des trous de guidage 402 aménagés dans le support 40 du dispositif d'alignement. Ce mouvement continue jusqu'à ce que le composant 1 vienne entre les mâchoires 410 ouvertes. Vu le montage flottant de la broche 3 décrit plus haut, un positionnement exact de la broche 3 relativement au dispositif d'alignement 4 est possible via les moyens de guidage 312 et 402 décrits. A la figure 3A, on voit que le composant 1 a été introduit entre les mâchoires 410 ouvertes et que ce composant n'est pas correctement aligné relativement aux deux tiges en saillie de guidage 312, le désalignement ayant lieu dans le plan X,Y et autour d'un axe perpendiculaire audit plan. La figure 3A montre qu'en rapprochant les deux mâchoires 410, le composant 1 va s'aligner correctement de par la forme particulière des mâchoires aptes à guider les pattes de contact du composant jusqu'à ce que ce dernier soit entièrement enfermé entre les deux mâchoires 410, ce qui correspond à un alignement parfait du composant 1, respectivement de ses pattes de contact par rapport aux deux tiges de guidage 312. On voit bien que pour l'alignement les mâchoires 410 agissent en poussant les pattes du composant 1 et non le boîtier. L'homme du métier comprend donc que le mouvement de rapprochement des mâchoires 410 doit s'effectuer avec douceur afin de ne pas risquer de briser ou tordre une patte de contact. A la figure 3B, on voit que le rapprochement des mâchoires 410 a permis d'aligner le composant 1 relativement au plan et à l'axe mentionné ci-dessus. La position du composant 1 et notamment de ses pattes est ainsi exactement connue relativement aux tiges en saillie 312 de la broche 3. Lors de cette opération d'alignement, le composant 1 est resté fixé à l'extrémité de saisie 344 de la broche 3 par aspiration.

En variante, si l'effort à exercer par les mâchoires 410 sur les pattes afin d'aligner le composant 1 est trop important et risque de briser ou tordre lesdites pattes, il est aussi possible de prévoir une surface d'appui 403 (voir figure 2A) entre les mâchoires 410 afin de recevoir le composant à aligner. Le montage élastique de la broche 3 empêche un écrasement du composant 1 sur la surface d'appui 403 lors du rapprochement de la broche 3 et du dispositif 4. Lors du rapprochement des mâchoires 410 afin d'aligner le composant, l'aspiration dans la broche peut ainsi être coupée vu que le composant est soutenu par la surface d'appui 403, ce qui diminue la résistance à l'alignement offerte par le composant.

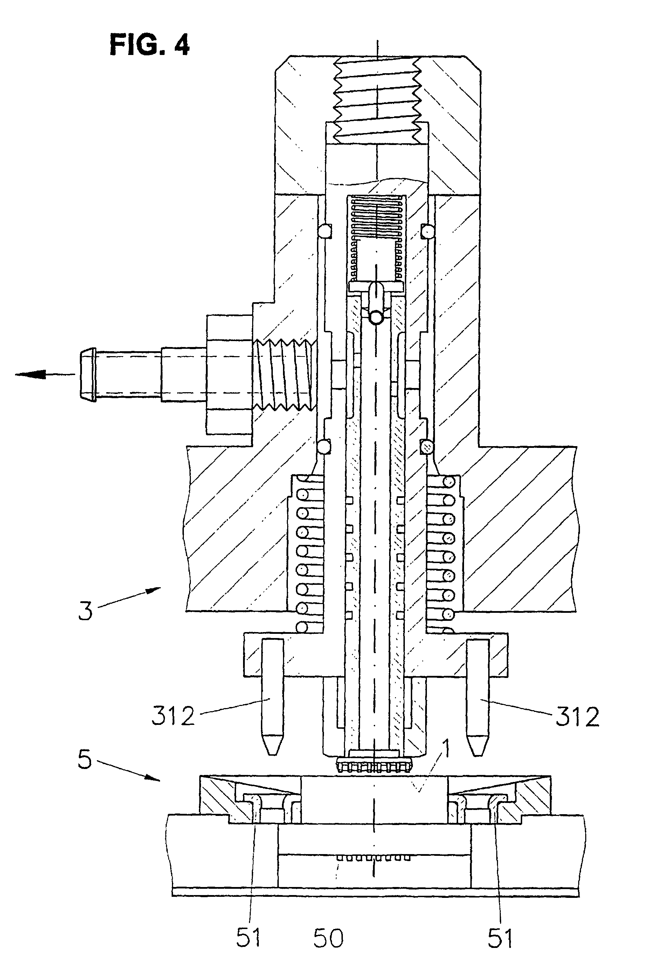

Maintenant que la position du composant 1 est exactement connue relativement aux tiges 312, l'aspiration est rétablie si nécessaire, les mâchoires 410 sont écartées et la broche 3 est écartée du dispositif d'alignement 4 jusqu'à ce que les tiges en saillie 312 soient entièrement dégagées des trous de guidage 402. Le composant 1 est alors emmené vers le poste de test comme on le voit à la figure 4.

Le poste de test 5 comprend notamment une pluralité de pistes de contact 50, correspondant chacune à une patte de contact du composant 1, chacune desdites pistes étant séparément reliée électriquement à une unité de test électronique, non représentée sur la figure, ladite unité de test étant apte à vérifier le fonctionnement du point de vue électronique du composant 1. Le poste de test 5 comprend en outre deux moyens de guidage 51, aptes à recevoir les moyens de guidage de la broche 3, en particulier les tiges de guidage 312. La position relative des pistes de contact 50 et des moyens de guidage 51 est exactement connue. Lorsqu'une broche 3 est approchée du poste de test 5, comme représenté sur la figure 4, les deux tiges de guidage 312 sont tout d'abord engagées dans les moyens de guidage 51 de manière à aligner correctement la broche 3 relativement au poste de test 5. Un alignement parfait de la broche 3 relativement au poste de test 5 est possible de par la construction flottante de la broche 3 décrite précédemment. Le rapprochement de la broche 3 relativement au poste de test 5 se poursuit jusqu'à ce que les pattes de contact du composant 1 arrivent en contact avec les pistes de contact 50 du poste de test. Vu le montage élastique de la broche 3, il n'y a aucun risque d'écrasement ou de déformation des pattes de contact du composant 1.

Vu que d'une part les pattes de contact du composant 1 étaient exactement alignées relativement aux tiges de guidage 312 sur la broche 3 et que d'autre part, par construction, les pistes de contact 50 sont exactement alignées relativement aux moyens de guidage 51, la mise en correspondance des tiges de guidage 312 et des moyens de guidage 51 amène de manière sûre chaque patte de contact sur la piste de contact qui lui correspond.

Le test électronique du composant 1 peut maintenant être effectué, le composant restant fixé à la broche 3 par aspiration. Puis la broche 3 est éloignée du poste de test 5 et pour un test réussi, peut être dirigée vers un poste de conditionnement ou de stockage de composant ou alors, profitant du fait que le composant 1 reste aligné sur la broche 3, être dirigée vers un poste de fixation du composant sur un socle ou de soudure des pattes sur des pistes d'un circuit imprimé. L'homme du métier comprend qu'un tel poste de fixation possède essentiellement les mêmes éléments que ceux décrits pour le poste de test de la figure 4, l'approche et l'alignement du composant 1, respectivement des pattes dudit composant relativement au socle ou aux pistes du circuit imprimé se faisant exactement comme décrit, l'opération de test étant remplacée par l'opération de fixation adéquate. Dans le cas où le test sur le poste de test n'est pas réussi, la broche est emmenée vers un poste de récupération des composants faillis.

La broche de saisie 3 ainsi que le dispositif d'alignement 4 et le poste de test 5 ou le poste de fixation ont été décrits comme étant des dispositifs séparés et indépendants. En fait ces éléments appartiennent à un même dispositif pouvant être configuré différemment selon les applications et les besoins. De même l'utilisation simultanée d'un seul élément a été décrite alors que plusieurs desdits éléments peuvent fonctionner simultanément.

Selon un exemple d'application, le porte-composant 2 de la figure 1 peut être disposé sur une ligne ou un carrousel de production. En un endroit déterminé de cette ligne de production, généralement lorsque la fabrication ou l'assemblage du composant 1 est achevé, une ou plusieurs broches de saisie 3 peuvent être actionnées simultanément pour venir saisir chacune un composant comme décrit précédemment, ladite ou lesdites broches étant ensuite simultanément présentées chacune devant un dispositif d'alignement 4 comme décrit précédemment, puis une fois que les composants sont alignés, les broches sont présentées simultanément chacune à un poste de test 5 ou à un poste de fixation. Selon une autre variante, les porte-composants 2, le dispositif d'alignement 4 ainsi que le poste de test 5 et/ou le poste de fixation peuvent être disposés sur une ligne ou un carrousel de production, la broche de saisie 3 pouvant être disposée à l'extrémité d'un bras robotisé apte à déplacer ladite broche en face de chacun des éléments mentionnés. D'autres configurations d'un dispositif de saisie et d'alignement pour le test et/ou la fixation d'un composant peuvent être envisagées, l'homme du métier étant apte à adapter les enseignements donnés ici à son problème.

Bien que la description ci-dessus et les figures se rapportent plus particulièrement au cas de l'alignement de composants électroniques encapsulés dans un boîtier de type dual in line, l'homme du métier comprendra que le dispositif selon l'invention peut aisément être adapté pour l'alignement de composants de pratiquement n'importe quel type, comprenant des pattes de contact sur une, deux, ou quatre faces latérales du boîtier, ou un réseau de pattes sur la surface inférieure du boîtier, de type CGA ou BGA par exemple, en vue du test ou de n'importe quelle autre opération nécessitant un alignement du composant, respectivement de ses pattes. En particulier la forme des mâchoires 41 servant à l'alignement du composant sera à adapter selon le type, la forme et les dimensions du composant à aligner.

Diverses caractéristiques techniques constructives ont été décrites ou représentées concernant la broche de saisie 3 et le dispositif d'alignement 4. Il est évident que ces caractéristiques peuvent être adaptées, par exemple les moyens prévus pour donner de l'élasticité et rendre flottante la broche 3 peuvent être différents de ce qui a été décrit plus haut, ou alors les moyens d'alignement prévus sur le dispositif 4 peuvent ne prévoir qu'une seul branche de pince mobile ou alors un actionnement de cette pince différent de ce qui a été décrit.

## Revendications

1. Dispositif de saisie et d'alignement d'un composant électronique constitué d'un boîtier muni de pattes de contact, sur une broche de saisie (3), comprenant un dispositif d'alignement (4) apte à agir sur les pattes dudit composant électronique afin d'aligner ce dernier relativement à des moyens de guidage (312) de ladite broche de saisie (3), ledit dispositif d'alignement (4) comprenant une pince (41) constituée de deux branches mobiles, chacune étant montée en pivotement autour d'un axe de pivotement (412), chaque branche portant une mâchoire (410), les mâchoires étant aptes à se rapprocher ou s'éloigner sous l'action de moyens d'actionnement (42, 43), chaque mâchoire (410) possèdant une forme apte à aligner les pattes de contact d'un composant (1) disposé entre lesdites mâchoires lors du rapprochement des mâchoires
**caractérisé en ce que**, ladite forme comprend une première surface d'alignement rectiligne, essentiellement perpendiculaire à l'axe de rapprochement desdites mâchoires, la longueur de ladite première surface d'alignement étant au moins égale à la distance hors-tout séparant les pattes situées aux deux extrémités d'une ligne de pattes de contact, ainsi que deux surfaces d'alignement secondaires disposées perpendiculairement au plan d'appui du composant électronique sur la broche de saisie et obliquement relativement à ladite première surface d'alignement, chacune disposée à une extrémité de ladite première surface d'alignement, de manière à entourer partiellement ledit composant.

2. Dispositif selon la revendication 1, **caractérisé en ce que** le moyen d'actionnement est constitué d'une tige (42) munie d'une butée (420) sur une de ses extrémités, une pluralité de billes (43) étant disposées entre une portion de ladite butée et une portion oblique (411) desdites branches de pince (41), le déplacement longitudinal de la tige dans un sens ou dans l'autre commandant l'écartement ou le rapprochement des mâchoires (410) de la pince (41).

3. Dispositif selon l'une des revendications précédentes, **caractérisé en ce que** le dispositif d'alignement comprend en outre une surface d'appui (403) apte à recevoir une surface du composant à aligner.

4. Dispositif selon l'une des revendications précédentes, **caractérisé en ce que** les moyens de guidage de la broche de saisie (3) sont constitués d'au moins deux tiges en saillie (412) parallèles entre elles, chacune desdites tiges étant apte à pénétrer dans un orifices de guidage (402) correspondant du dispositif d'alignement (4).

5. Dispositif selon la revendication 4, **caractérisé en ce que** chacune des tiges en saillie (412) est également apte à pénétrer dans un orifice de guidage (51) d'un poste de test de composant (5) ou d'un poste de fixation de composant.

6. Dispositif selon l'une des revendications précédentes, **caractérisé en ce que** le composant (1) est maintenu par aspiration sur la broche de saisie (3).

7. Dispositif selon l'une des revendications précédentes, **caractérisé en ce que** le composant (1) est maintenu par aspiration sur une extrémité de saisie (344) de la broche de saisie (3), ladite extrémité de saisie étant montée de manière flottante relativement à un support de broche (30).

8. Utilisation d'un dispositif selon l'une des revendications précédentes pour le test de composants électroniques sur un poste de test.

9. Utilisation d'un dispositif selon l'une des revendications 1 à 7 pour la fixation d'un composant électronique sur un socle ou une portion d'un circuit imprimé.

## Claims

1. Device for gripping and aligning an electronic component comprising a housing provided with contact pins, on a gripping spindle (3), comprising an alignment device (4) able to act on the pins of said electronic component in order to align the latter relative to guiding means (312) of said gripping spindle (3), said aligning device (4) comprising a clamp (41) constituted of two mobile branches, each being rotably mounted around a rotational axis (412), each branch bearing a jaw (410), the jaws being able to move closer or apart through the action of operating means (42, 43), each jaw (410) having a shape suitable for aligning the contact pins of a component (1) disposed between said jaws, when the jaws are moved closer together
**characterized in that** said shape comprises a first rectilinear aligning surface, essentially perpendicular to the moving direction of said jaws, the length of said first alignment surface being at least equal to the overall distance between the pins situated on the two extremities of a line of contact pins, as well as two secondary alignment surfaces disposed perpendicularly to the supporting plane of the electronic component on the gripping spindle and obliquely relative to said first aligning surface, each being disposed at one extremity of said first aligning surface, so as to partially surround said component.

2. Device according to claim 1, **characterized in that** the operating means are constituted of a rod (42) fitted with a stop (420) on one of its extremities, a plurality of balls (43) being disposed between a portion of said stop and an oblique portion (411) of said branches of the clamp (41), the longitudinal displacement of the rod in one or the other direction controlling the moving apart or closer of the jaws (410) of the clamp (41).

3. Device according to one of the preceding claims, **characterized in that** the aligning device further comprises a supporting surface (403) able to receive a surface of the component to be aligned.

4. Device according to one of the preceding claims, **characterized in that** the guiding means of the gripping spindle (3) are constituted of at least two protruding rods (412) parallel to each other, each of said rods being able to enter into a corresponding guiding opening (402) of the aligning device (4).

5. Device according to claim 4, **characterized in that** each of the protruding rods (412) is also able to enter into a guiding opening (51) of a component testing station (5) or a component fitting station.

6. Device according to one of the preceding claims, **characterized in that** the component (1) is held on the gripping spindle by suction.

7. Device according to one of the preceding claims, **characterized in that** the component (1) is held by suction on a gripping extremity (344) of the gripping spindle (3), said gripping extremity being mounted floatingly relative to a spindle support (30).

8. Use of a device according to one of the preceding claims for testing electronic components on a testing station.

9. Use of a device according to one of the claims 1 to 7 for fitting an electronic component on a socket or a portion of a printed circuit.

## Patentansprüche

1. Vorrichtung für das Erfassen und das Ausrichten einer elektronischen Komponente, bestehend aus einem Gehäuse versehen mit Kontaktsteckern, auf einer Greifspindel (3), enthaltend eine Ausrichtungsvorrichtung (4), welche in der Lage ist, auf die Stecker von besagter elektronischen Komponente einzuwirken, um Letztere in Bezug auf die Führungsmittel (312) von besagter Greifspindel (3) auszurichten, wobei besagte Ausrichtungsvorrichtung (4) eine Klemme (41) bestehend aus zwei beweglichen Griffen enthält, jeder rotierend um eine Rotationsachse (412) angebracht, wobei jeder Griff eine Klemmbacke (410) trägt, wobei die Klemmbacken in der Lage sind, sich unter Einwirkung von Antriebsmitteln (42, 43) anzunähern und wegzubewegen, wobei jede Klemmbacke (410) eine Form hat, die erlaubt, die Kontaktstecker einer zwischen besagten Klemmbacken angeordneten Komponente (1) während der Annäherung der Klemmbacken auszurichten,
**dadurch gekennzeichnet, dass** besagte Form eine erste geradlinige Ausrichtungsfläche enthält, im Wesentlichen senkrecht zur Annäherungsachse besagter Klemmbacken, wobei die Länge besagter erster Ausrichtungsfläche mindestens gleich der über alles gemessenen Distanz zwischen den Steckern an den beiden Enden einer Linie von Kontaktsteckern ist, sowie zwei sekundäre Ausrichtungsflächen, welche senkrecht zur Stützfläche der elektronischen Komponente auf der Greifspindel und schräg in Bezug auf besagte erste Ausrichtungsfläche angeordnet sind, wobei jede an einem Ende besagter erster Ausrichtungsfläche angebracht ist, um besagte Komponente teilweise zu umschliessen.

2. Vorrichtung gemäss dem Anspruch 1, **dadurch gekennzeichnet, dass** die Antriebsmittel aus einer Stange (42) mit einem Anschlag (420) an einem seiner Enden bestehen, wobei eine Vielzahl von Kugeln (43) zwischen einem Teil des besagten Anschlags und einem schrägen Teil (411) des besagten Griffs der Klemme (41) angebracht sind, wobei die Längsverschiebung der Stange in die eine oder andere Richtung das Wegführen oder das Zusammenführen der Klemmbacken (410) der Klemme (41) bewirkt.

3. Vorrichtung gemäss einem der vorhergehenden Ansprüche, **dadurch gekennzeichnet, dass** die Ausrichtungsvorrichtung ausserdem eine Stützfläche (403) enthält, die eine Fläche der auszurichtenden Komponente empfangen kann.

4. Vorrichtung gemäss einem der vorhergehenden Ansprüche, **dadurch gekennzeichnet, dass** die Führungsmittel der Greifspindel (3) aus mindestens zwei zu einander parallelen vorstehenden Stiften (412). bestehen, wobei jeder besagter Stift in der Lage ist, in eine entsprechende Führungsöffnung (402) der Ausrichtungsvorrichtung (4) einzudringen.

5. Vorrichtung gemäss dem Anspruch 4, **dadurch gekennzeichnet, dass** jeder der vorstehenden Stifte (412) ebenfalls in der Lage ist, in eine Führungsöffnung (51) einer Komponententeststation (5) oder einer Komponentenbefestigungsstation einzudringen.

6. Vorrichtung gemäss einem der vorhergehenden Ansprüche, **dadurch gekennzeichnet, dass** die Komponente (1) durch Ansaugen auf der Greifspindel (3) gehalten wird.

7. Vorrichtung gemäss einem der vorhergehenden Ansprüche, **dadurch gekennzeichnet, dass** die Komponente (1) durch Ansaugen auf einem Greifteil (344) der Greifspindel (3) gehalten wird, wobei besagtes Greifteil lose in Bezug auf ein Spindelgestell (30) angebracht ist.

8. Gebrauch einer Vorrichtung gemäss einem der vorhergehenden Ansprüche für das Testen von elektronischen Komponenten auf einer Teststation.

9. Gebrauch einer Vorrichtung gemäss einem der Ansprüche 1 bis 7 für das Befestigen von elektronischen Komponenten auf einem Sockel oder einer Portion von einem gedruckten Schaltkreis.
